# EUROPEAN PATENT APPLICATION

(11) **EP 1 560 469 A1**
(43) Date of publication of application: **03.08.2005**
(21) Application number: 03812281.8
(22) Date of filing: 05.11.2003
(51) Int. Cl.: H05B 33/22, H05B 33/14, C09K 11/06

(54) **ORGANIC ELECTROLUMINESCENT DEVICE**

(30) Priority: 06.11.2002 JP 2002322773
(71) Applicant: Kabushiki Kaisha Toyota Jidoshokki, Kariya-shi, Aichi-ken 448-8671 (JP)
(72) Inventor: NAGARA, Yoshiaki K.K. Toyota Jidos Hokki, Kariya-shi, Aichi 448-8671 (JP); MURASAKI, Takanori K.K. Toyota Jidos Hokki, Kariya-shi, Aichi 448-8671 (JP); YAMAMOTO, Ichiro K.K. Toyota Jidos Hokki, Kariya-shi, Aichi 448-8671 (JP)
(74) Representative: Leson, Thomas Johannes Alois, Dipl.-Ing.
(86) International application number: PCT/JP2003/014108
(87) International publication number: WO 2004/052057

(57) **Abstract**

The electron transport layer contained in the organic EL device according to the present invention contains at least a first organic compound and a second organic compound. The first organic compound possesses higher electron mobility than the second organic compound, and the second organic compound possesses a higher glass transition temperature than the first organic compound. For this reason, the organic EL device according to the present invention has a long life and a high luminous efficiency. The first organic compound is preferably a silole derivative, and the second organic compound is preferably a quinolinolate metal complex.

## Description

### TECHNICAL FIELD

The present invention relates to an organic electroluminescent device (organic EL device).

### BACKGROUND ART

Organic EL devices are attracting attention as a device for use in next-generation displays. In a typical organic EL device, an anode consisting of a transparent conductive material, such as indium tin oxide (ITO) is provided on a glass substrate, and arranged on the anode are, in order, a hole injection layer, a hole transport layer, a light-emitting layer, an electron transport layer, and a cathode. When a direct-current voltage is applied between the anode and the cathode, holes are injected from the anode into the hole injection layer and electrons are injected from the cathode into the electron transport layer. The injected holes are transported via the hole transport layer to the light-emitting layer and the injected electrons are also transported to the light-emitting layer. The holes and the electrons recombine at the light-emitting layer, which results in light being emitted.

In recent years it has been desired for organic EL devices to have a long life. Initial luminance half-life is known as an indicator which shows the life of an organic EL device. Initial luminance half-life is the duration for the luminance of an organic EL device to decline to half of its initial luminance; so that the longer this half-life is, the longer the life of an organic EL device is taken to be.

Major factors for shortening the initial luminance half-life include, for example, crystallization of the organic compound in the organic EL device due to heat generated from current injection or change over time, electrochemical degradation such as oxidative degradation and reductive degradation of the organic compound, chemical degradation of the organic compound, agglomeration of the organic compound, peeling among adjacent layers, and complex formation among adjacent layers.

Organic EL devices which comprise an electron transport layer consisting of a quinolinolate metal complex, especially tris-(8-quinolinolato) aluminum, abbreviated as Alq3, or bis(2-methyl-8-quinolinolato)(p-phenylphenolato) aluminum, abbreviated as BAlq, are known for possessing a relatively long initial luminance half-life. However, the electron mobility in an electron transport layer consisting of Alq3 or BAlq is not rather high. This means that the luminous efficiency for an organic EL device which comprises an electron transport layer consisting of Alq3 or BAlq is not very high.

Examples of other known materials for forming the electron transport layer include those disclosed in Japanese Laid-Open Patent Publication Nos. 09-87616, 09-194487 and 2002-100479.

### DISCLOSURE OF THE INVENTION

It is an object of the present invention to provide an organic EL device having a long life and high luminous efficiency.

To achieve this object, the following organic EL device is provided in one aspect of the present invention. Such an organic EL device has a pair of electrodes and a plurality of organic compound layers, which include an electron transport layer, provided between the pair of electrodes. The electron transport layer includes at least a first organic compound and a second organic compound. The first organic compound possesses a higher electron mobility than the second organic compound. The second organic compound possesses a higher glass transition temperature than the first organic compound.

Another aspect of the present invention provides the following organic EL device. This organic EL device has a pair of electrodes and a plurality of organic compound layers, which include an electron transport layer, provided between the pair of electrodes. The electron transport layer includes at least a first organic compound and a second organic compound. And the first organic compound possesses a higher electron mobility than the second organic compound. The first and second organic compounds are selected so that a second organic electroluminescent device has a longer initial luminance half-life than a first organic electroluminescent device, provided that the first organic electroluminescent device has an electron transport layer formed only of the first organic compound, and the second organic electroluminescent device has an electron transport layer formed only of the second organic compound.

### BRIEF DESCRIPTION OF THE DRAWING

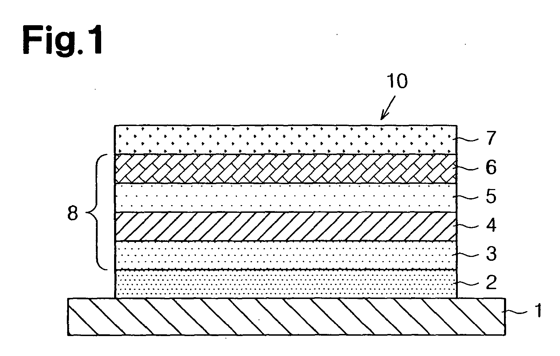

Fig. 1 is a cross-sectional view of an organic EL device in one embodiment according to the present invention.

### BEST MODE FOR CARRYING OUT THE INVENTION

One embodiment according to the present invention will now be explained based on Fig. 1.

As illustrated in Fig. 1, an organic EL device 10 according to the present embodiment has a substrate 1, an anode 2 provided on the substrate 1, organic layers 8 provided on the anode 2 and a cathode 7 provided on the organic layers 8. The organic layers 8 comprise, as an organic compound layer, a hole injection layer 3, a hole transport layer 4, a light-emitting layer 5 and an electron transport layer 6. These layers 3 to 6 are arranged in order from the side face of the organic layers 8 facing the anode 2 towards the side face of the organic layers 8 facing the cathode 7.

The hole injection layer 3 and the hole transport layer 4 are not always required, and may be omitted. However, by comprising a hole injection layer 3 and a hole transport layer 4 in the organic layers 8, the luminous efficiency for the organic EL device 10 is improved and the initial luminance half-life for the organic EL device 10 is prolonged.

The substrate 1 functions as a support for the organic EL device 10. The substrate 1 may be a glass plate, plastic sheet, plastic film, metal sheet or metal foil, or alternatively it may be formed of a ceramic such as silicon. The substrate 1 is preferably formed of polyethylene terephthalate, polycarbonate or polymethacrylate, as these have excellent moisture resistance, shock resistance, heat resistance and surface smoothness. If moisture resistance needs to be improved, a silicon nitride film, silicon oxide film or a silicon oxide nitride film may also be provided on the surface of the substrate 1. However, if light (visible light) emitted from the light-emitting layer 5 is to exit from the organic EL device 10 via the substrate 1, the substrate 1 must be transmissive to visible light.

The anode 2 has the role of injecting holes into the hole injection layer 3. Although the material forming the anode 2 may be a metal, an alloy, an electroconductive compound or a mixture thereof, the material preferably possesses low electric resistivity and a high work function. Examples of a preferable material for forming the anode 2 include a metal oxide or metal nitride such as ITO, tin oxide, zinc oxide, a mixture of zinc oxide and indium oxide, and titanium nitide; a metal such as gold, platinum, silver, copper, aluminum, nickel, lead, chrome, molybdenum, tungsten, tantalum and niobium; and a conductive polymer such as polyaniline, polythiophene, polypyrrole and polyphenylenevinylene. The anode 2 may be formed of a single type of material, or may be of a plurality of types of material. The thickness of the anode 2 is preferably from 10 nm to 1 µm, and more preferably from 10 nm to 300 nm. The anode 2 may be formed by a well-known process, such as sputtering, ion-plating, vacuum vapor deposition and spin coating. If light (visible light) emitted from the light-emitting layer 5 is to exit from the organic EL device 10 via the anode 2, the anode 2 must be transmissive to visible light. The anode 2 transmittance with respect to visible light is preferably 10% or more.

The hole injection layer 3 has the role of injecting the holes injected from the anode 2 into the hole transport layer 4, and the role of adhering the anode 2 to the organic layers 8. The material forming the hole injection layer 3 preferably possesses a high adherence to the anode 2, a low ionization potential and a high glass transition temperature. Examples of the material for forming the hole injection layer 3 include phthalocyanine derivatives, porphyrin derivatives, polyphenylenevinylene derivatives, starburst amine derivatives, polyaniline and polythiophene. Preferable phthalocyanine derivatives include copper phthalocyanine and metal-free phthalocyanines, and preferable starburst amine derivatives include 4,4',4"-tris(3-methylphenylphenyl-amino)triphenylamine. The hole injection layer 3 may be formed of a single type of material, or may be of a plurality of types of material. The thickness of the hole injection layer 3 is preferably from 5 nm to 100 nm, and more preferably from 10 nm to 50 nm. The hole injection layer 3 may be formed by a well-known process, such as vacuum vapor deposition, spin coating, dipping and the like.

The hole transport layer 4 has the role of transporting the injected holes to the light-emitting layer 5. The material forming the hole transport layer 4 is preferably such that it can be easily injected with the holes from the hole injection layer 3 or anode 2, and has the ability to efficiently transport the injected holes to the light-emitting layer 5. Examples of the material for forming the hole transport layer 4 include triarylamine derivatives, a compound having a repeating structure of a triphenylamine structure as a main chain and/or side chain, triphenylmethane derivatives, hydrazone derivatives, oxazole derivatives, oxadiazole derivatives, triazole derivative, triphenylmethane derivatives, fluorenyl diphenylamine derivatives, benzidine derivatives, pyrazoline derivatives, stilbene derivatives, styrylamine derivatives, polyphenylenevinylene derivatives, carbazole derivatives, phenylenediamine derivatives, spiro compounds, and furthermore, the above-described materials mentioned as the material for forming the hole injection layer 3. Preferable triarylamine derivatives include triphenylamine and the dimer, trimer, tetramer and pentamer of triphenylamine. Preferable benzidine derivatives include N,N'-dinapthyl-N,N'-diphenylbenzidine. Preferable carbazole derivatives include 4,4'-N,N'-dicarbazolebiphenyl and poly(N-vinylcarbazole). The hole transport layer 4 may be formed of a single type of material, or of a plurality of types of material. The thickness of the hole transport layer 4 is preferably from 5 nm to 100 nm, and more preferably from 10 nm to 50 nm. The hole transport layer 4 may be formed by a well-known process, such as vacuum vapor deposition, spin coating, dipping and the like.

The light-emitting layer 5 emits light (visible light) upon the recombination of holes injected and transported from the anode 2 with electrons injected and transported from the cathode 7 at the light-emitting layer 5. Excitons are generated upon the recombination of the holes with the electrons, and when these excitons return to their ground state, light is emitted. The material forming the light-emitting layer 5 preferably possesses a high fluorescence quantum yield, the ability to efficiently transport holes and electrons and a high glass transition temperature. Examples of the material for forming the light-emitting layer 5 include distyrylallylene derivatives, distyrylbenzene derivatives, distyrylamine derivatives, quinolinolate metal complexes, triarylamine derivatives, azomethine derivatives, oxadiazole derivatives, pyrazoloquinoline derivatives, silole derivatives (silacyclopentadiene derivatives), naphthalene derivatives, anthracene derivatives, dicarbazole derivatives, perylene derivatives, oligothiophene derivatives, cumarin derivatives, pyrene derivatives, tetraphenylbutadiene derivatives, benzopyrane derivatives, europium complexes, rubrene derivatives, quinacridone derivatives, triazole derivatives, benzoxazole derivatives, and benzothiazole derivatives. Preferable quinolinolate metal complexes include Alq3 and BAlq, preferable triarylamine derivatives include a tetramer of triphenylamine, and preferable distyrylallylene derivatives include 4,4'-bis(2,2'-diphenylvinyl) biphenyl (DPVBi). The light-emitting layer 5 may be formed of a single layer, or of a plurality of layers. The light-emitting layer 5 may be formed of a single material, or of a plurality of materials. To improve luminous efficiency of the organic EL device 10 and to prolong its initial luminance half-life, the light-emitting layer 5 may be constituted by a host compound and a guest compound which is doped into the host compound. The concentration of the guest compound to be doped may be uniform throughout the entire light-emitting layer 5, or may be non-uniform. The thickness of the light-emitting layer 5 is preferably from 1 nm to 100 nm, and more preferably from 10 nm to 50 nm. The light-emitting layer 5 may be formed by a well-known process, such as vacuum vapor deposition and the like.

The electron transport layer 6 has the role of transporting the electrons injected from the cathode 7 to the light-emitting layer 5, and the role of preventing the excitons formed at the light-emitting layer 5 from scattering and quenching at the cathode 7. The electron transport layer 6 may be formed of two types of organic compound, namely a first and a second organic compounds, or may comprise these two types of organic compound as a main constituent. The first and second organic compounds are preferably such that the electrons can be easily injected into them from the cathode 7, and have the ability to efficiently transport the injected electrons. The first and second organic compounds must satisfy at least two requirements including the first of the following three requirements.

Requirement 1: That the electron mobility for the first organic compound be higher than the electron mobility for the second organic compound within the range of electric field intensity applied during actual use of an organic EL device.

Requirement 2: That the glass transition temperature of the second organic compound be higher than the glass transition temperature of the first organic compound.

Requirement 3: That a second organic electroluminescent device has a longer initial luminance half-life than a first organic electroluminescent device, provided that the first organic electroluminescent device has an electron transport layer 6 formed only of the first organic compound, and the second organic electroluminescent device has an electron transport layer 6 formed only of the second organic compound.

The first organic compound is preferably a silole derivative. Preferable silole derivatives are those which are disclosed in Japanese Laid-Open Patent Publication No. 09-87616 and Japanese Laid-Open Patent Publication No. 09-194487, and more preferable the silole derivative is 2,5-bis(6'-(2',2"-bipyridyl))-1,1-dimethyl-3,4-diphenylsilole or 2,5-bis(6'-(2',2"-bipyridyl))-1,1-dimethyl-3,4-bis(2-methylphenyl) silole.

The second organic compound is preferably a metal complex; a phenanthroline derivative such as bathocuproin and bathophenanthroline; or a triazole derivative such as 3-(4-biphenyl-4-(4-ethylphenyl)-5-(4-tert-butylphenyl)-1,2,4-triazole. Examples of a preferable metal complex include Alq3, BAlq, and a quinolinolate metal complex such as tris(2-methyl-8-quinolinolato) aluminum, tris(5-methyl-8-quinolinolato) aluminum, mono(4-methyl-8-quinolinolato) bis(8-quinolinolato) aluminum, mono(4-ethyl-8-quinolinolato) mono(4-methyl-8-quinolinolato) mono(8-quinolinolato) aluminum, tris(3,4-dimethyl-8-quinolinolato) aluminum, tris(4-methoxy-8-quinolinolato) aluminum, tris(4,5-dimethyl-8-quinolinolato) aluminum, tris(4,6-dimethyl-8-quinolinolato) aluminum, tris(5-chloro-8-quinolinolato) aluminum, tris(5-bromo-8-quinolinolato) aluminum, tris(5,7-dichloro-8-quinolinolato) aluminum, tris(5-cyano-8-quinolinolato) aluminum, tris(5-sulfonyl-8-quinolinolato) aluminum, tris(5-propyl-8-quinolinolato) aluminum, bis(8-quinolinolato) zinc, bis(2-methyl-8-quinolinolato) zinc, bis(2,4-dimethyl-8-quinolinolato) zinc, bis(2-methyl-5-chloro-8-quinolinolato) zinc, bis(2-methyl-5-cyano-8-quinolinolato) zinc, bis(3,4-dimethyl-8-quinolinolato) zinc, bis(4,6-dimethyl-8-quinolinolato) zinc, bis(5-chloro-8-quinolinolato) zinc, bis(5,7-dichloro-8-quinolinolato) zinc, bis(benzo[f]-8-quinolinolato) zinc, bis(8-quinolinolato) beryllium, bis(2-methyl-8-quinolinolato) beryllium, bis(2,4-dimethyl-8-quinolinolato) beryllium, bis(2-methyl-5-chloro-8-quinolinolato) beryllium, bis(2-methyl-5-cyano-8-quinolinolato) beryllium, bis(3,4-dimethyl-8-quinolinolato) beryllium, bis(4,6-dimethyl-8-quinolinolato) beryllium, bis(5-chloro-8-quinolinolato) beryllium, bis(4,6-dimethyl-8-quinolinolato) beryllium, bis(10-hydroxybenzo[h]quinolinolato) beryllium, bis(8-quinolinolato) magnesium, bis(2-methyl-8-quinolinolato) magnesium, bis(2,4-dimethyl-8-quinolinolato) magnesium, bis(2-methyl-5-chloro-8-quinolinolato) magnesium, bis(2-methyl-5-cyano-8-quinolinolato) magnesium, bis(3,4-dimethyl-8-quinolinolato) magnesium, bis(4,6-dimethyl-8-quinolinolato) magnesium, bis(5-chloro-8-quinolinolato) magnesium, bis(5,7-dichloro-8-quinolinolato) magnesium, bis(10-benzo[h]quinolinolato) magnesium, tris(8-quinolinolato) indium, 8-quinolinolato lithium, tris(5-chloro-8-quinolinolato) gallium, bis(5-chloro-8-quinolinolato) calcium, bis(2-methyl-8-quinolinolato)(triphenylsilanolato) aluminum, bis(2-methyl-8-quinolinolato)(diphenylmethylsilanolato) aluminum, bis(2-methyl-8-quinolinolato)(tert-butyldiphenylsilanolato) aluminum, bis(2-methyl-8-quinolinolato)(tris-(4,4-biphenyl)silanolato) gallium, bis(2-methyl-8-quinolinolato)(1-naphtholato) gallium, bis(2-methyl-8-quinolinolato)(2-naphtholato) gallium and bis(8-quinolinolato) copper.

If the electron transport layer 6 contains, in addition to the first organic compound and the second organic compound, a third organic compound, this third organic compound also preferably satisfies at least two requirements including the first of the above-described three requirements. Examples of the third organic compound include silole derivatives, quinolinolate metal complexes, oxazole derivatives, oxadiazole derivatives, phenanthroline derivatives, quinoxaline derivatives, quinoline derivatives, pyrrole derivates, benzopyrrole derivatives, pyrazole derivatives, thiazole derivatives, benzothiazole derivatives, thiadiazole derivatives, thionaphthene derivatives, imidazole derivatives, benzoimidazole derivatives, triazole derivatives, distyrylbenzene derivatives and spiro compounds. Quinolinolate metal complexes preferably have as a ligand 8-quinolinolato, 2-methyl-8-quinolinolato, 4-methyl-8-quinolinolato, 5-methyl-8-quinolinolato, 3,4-dimethyl-8-quinolinolato, 4-ethyl-8-quinolinolato, 4,5-dimethyl-8-quinolinolato, 4,6-dimethyl-8-quinolinolato, 4-methoxy-8-quinolinolato, 10-benzo[h]quinolinolato, benzo[f]-8-quinolinolato, a 8-quinolinolato dimer or 7-propyl-8-quinolinolato; and preferably have as the central metal aluminum, beryllium, zinc, magnesium, gallium, indium, copper, calcium, tin or lead.

The weight percentage of the first organic compound as a share of the electron transport layer 6 is preferably from 1% or more to 50% or less. The first organic compound preferably has a molecular weight of 400 or more. If the weight percentage of the first organic compound is from 1% or more to 50% or less, and if the first organic compound has a molecular weight of 400 or more, the initial luminance half-life of the organic EL device 10 is prolonged and the luminous efficiency is improved.

The electron transport layer 6 may be formed by co-depositing the first organic compound and the second organic compound, or may be formed by laminating a first layer consisting of the first organic compound with a second layer consisting of the second organic compound. When the electron transport layer 6 is formed by co-deposition, the respective concentrations of the first and the second organic compounds in the electron transport layer 6 may be either uniform or non-uniform in the thickness direction of the electron transport layer 6. When the electron transport layer 6 is formed by lamination, the second layer may be formed on top of the first layer, or the first layer may be formed on top of the second layer.

The thickness of the electron transport layer 6 is preferably from 5 nm to 100 nm, and more preferably from 5 nm to 50 nm. The electron transport layer 6 may be formed by a well-known process such as vacuum vapor deposition and the like. The electron transport layer 6 may also possess functions other than that of electron transportation, such as light emission or the like.

The cathode 7 has the role of injecting electrons into the electron transport layer 6. The material forming the cathode 7 may be a metal, an alloy, an electroconductive compound or a mixture thereof. The material forming the cathode 7 preferably possesses low electric resistivity and a small work function. Examples of a preferable material for forming the cathode 7 include a metal such as gold, silver, copper, aluminum, indium, calcium, tin and the like; an alloy such as an aluminum alloy, for example aluminum-calcium alloy or aluminum-lithium alloy, or a magnesium alloy, for example magnesium-silver alloy or magnesium-indium alloy; and the materials described above as a material for forming the anode 2. The cathode 7 may be formed of a single type of material, or may be of a plurality of types of material. The thickness of the cathode 7 is preferably from 5 nm to 1 µm, and more preferably from 10 nm to 500 nm. The cathode 7 may be formed by a well-known process such as vacuum vapor deposition, sputtering, ion-plating, electron beam vapor deposition and the like. If light (visible light) emitted from the light-emitting layer 5 is to exit from the organic EL device 10 via the cathode 7, the cathode 7 must be transmissive to visible light. The cathode 7 transmittance with respect to visible light is preferably 10% or more.

A cathode interface layer may be provided between the cathode 7 and the electron transport layer 6 for enhancing electron injection into the electron transport layer 6 from the cathode 7, or for enhancing the adhesion between the cathode 7 and the electron transport layer 6. Examples of the material for forming the cathode interface layer include fluorides, oxides, chlorides and sulfides of alkali metals, and those of alkaline earth metals, such as lithium fluoride, lithium oxide, magnesium fluoride, calcium fluoride, strontium fluoride and barium fluoride. The cathode interface layer may be formed of a single material or a plurality of materials. The thickness of the cathode interface layer is preferably from 0.1 nm to 10 nm, and more preferably from 0.3 nm to 3 nm. The cathode interface layer may have a uniform thickness or a non-uniform thickness. Further, the cathode interface layer may have an island-like shape and may be formed by a known process, such as vacuum vapor deposition.

The cathode interface layer may be formed by co-deposition of a material described above as the material for forming the electron transport layer 6 with a material described above as the material for forming the cathode 7.

A hole blocking layer may also be provided between the light-emitting layer 5 and the electron transport layer 6. The hole blocking layer prevents some of the holes injected and transported from the anode 2 to the light-emitting layer 5 from reaching the electron transport layer 6 without having recombined with an electron by blocking the passage of holes. This suppresses deterioration in luminous efficiency of the organic EL device. The material for forming the hole blocking layer preferably has an ionization potential greater than the ionization potential of the material forming the light-emitting layer 5. Examples of the material for forming a hole blocking layer include, among the materials described above as a material for forming the electron transport layer 6, those materials having an ionization potential greater than the ionization potential of the material forming the light-emitting layer 5. The ionization potential of a material forming the hole blocking layer is preferably greater than the ionization potential of the material forming the light-emitting layer 5 by 0.1 eV or more. In such a case, the hole blocking layer effectively blocks the passage of holes. The hole blocking layer may be formed of only one layer or of a plurality of layers. Further, the hole blocking layer may be formed of only one material or of a plurality of materials. The thickness of the hole blocking layer is preferably from 0.5 nm to 50 nm, and more preferably from 1 nm to 10 nm. The hole blocking layer may be formed by a known process, such as vacuum vapor deposition and the like.

The anode 2, organic layers 8 and cathode 7 provided on the substrate 1 may be provided in a reverse order. That is, the cathode 7 may be provided on the substrate 1, the organic layers 8 on the cathode 7, and the anode 2 on the organic layers 8. The hole injection layer 3, hole transport layer 4, light-emitting layer 5 and electron transport layer 6 contained in the organic layers 8 may be arranged as shown for the organic EL device 10 in Fig. 1 in order from the side face of the organic layers 8 facing the anode 2 towards the side face of the organic layers 8 facing the cathode 7. In this case also, the hole injection layer 3 and the hole transport layer 4 may be omitted and at least one of the anode 2 and the cathode 7 is transparent. A further example of an organic EL device formed as described above may comprise as necessary the above-described cathode interface layer or hole blocking layer.

Examples of the present invention will now be described. However, the present invention should not be limited to these examples as will be easily understood.

### Example 1

In Example 1, first, an anode 2 made of ITO and having a thickness of 190 nm was formed on a transparent glass substrate 1. The glass substrate 1 on which the anode 2 was arranged was washed by performing alkali cleaning and pure water cleaning. Then, after being dried, the glass substrate was washed by performing ultraviolet ozone cleaning. Then, a 10 nm thick hole injection layer 3 consisting of copper phthalocyanine represented by the Formula 1 below was deposited by vacuum vapor deposition onto the anode 2. The copper phthalocyanine deposition was carried out using a carbon crucible under a vacuum of approximately 5.0 x 10⁻⁵ Pa and at a deposition rate of 0.1 nm/s.

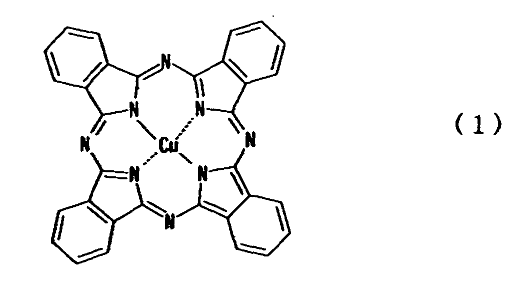

A 10 nm thick hole transport layer 4 consisting of a triphenylamine tetramer represented by the Formula 2 below was then deposited by vacuum vapor deposition onto the hole injection layer 3. The triphenylamine tetramer deposition was carried out using a carbon crucible under a vacuum of approximately 5.0 × 10⁻⁵ Pa and at a deposition rate of 0.1 nm/s.

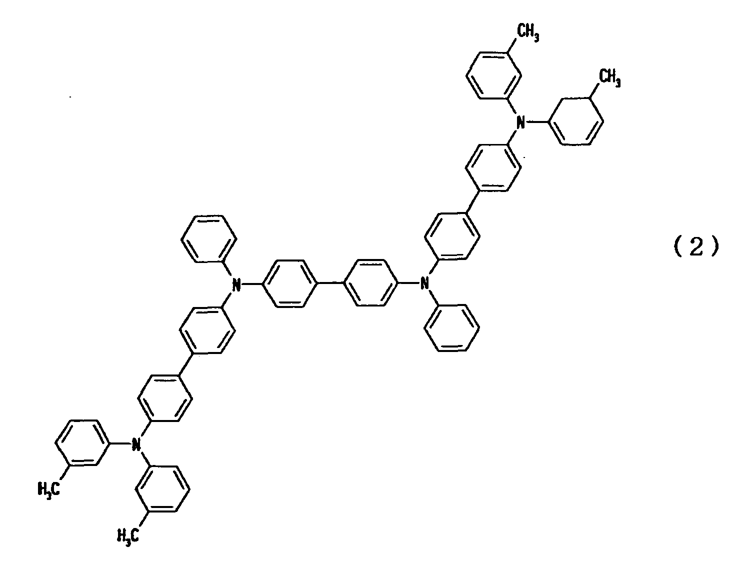

Then, as the light-emitting layer 5, a 30 nm thick light-emitting layer 5 consisting of DPVBi represented by the Formula 3 below was provided by vacuum vapor deposition onto the hole transport layer 4. The DPVBi deposition was carried out under a vacuum of approximately 5.0 × 10⁻⁵ Pa and at a deposition rate of 0.1 nm/s. The light-emitting layer 5 consisting of DPVBi emitted blue light.

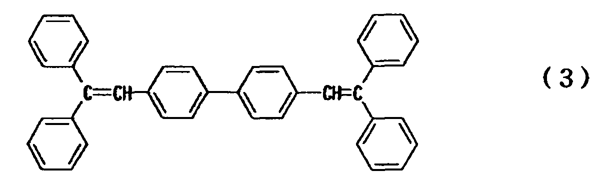

Subsequently, a 20 nm thick electron transport layer 6 was formed by co-depositing the following compounds onto the light-emitting layer 5 under a vacuum of approximately 5.0 x 10⁻⁵ Pa: 2,5-bis(6'-(2',2"-bipyridyl))-1,1-dimethyl-3,4-diphenylsilole as a first organic compound represented by the Formula 4 below and Alq3 as a second organic compound represented by the Formula 5 below. At this time, the deposition rate ratio of 2,5-bis(6'-(2',2"-bipyridyl))-1,1-dimethyl-3,4-diphenylsilole to Alq3 was adjusted so that the weight percentage of 2,5-bis(6'-(2',2"-bipyridyl))-1,1-dimethyl-3,4-diphenylsilole to the electron transport layer 6 was 1%. However, the sum of the 2,5-bis(6'-(2',2"-bipyridyl))-1,1-dimethyl-3,4-diphenylsilole deposition rate and Alq3 deposition rate was kept constant at approximately 0.1 nm/s. The 2,5-bis(6'-(2',2"-bipyridyl))-1,1-dimethyl-3,4-diphenylsilole is a type of silole derivative which has a molecular weight of 570.8. The Alq3 is a type of quinolinolate metal complex.

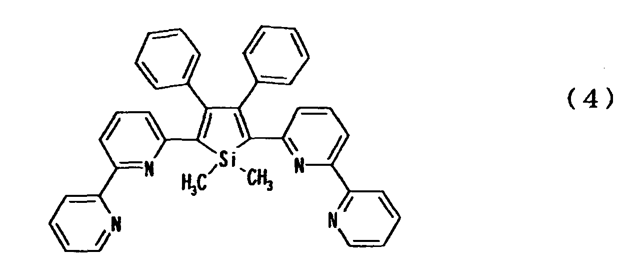

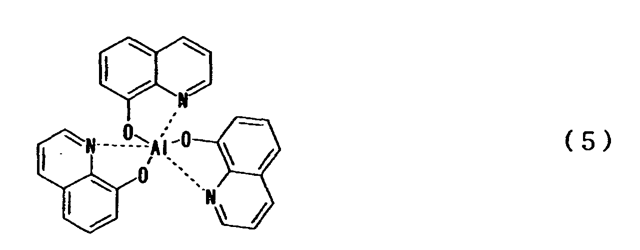

Comparison of the Alq3 and 2,5-bis(6'-(2',2"-bipyridyl))-1,1-dimethyl-3,4-diphenylsilole showed that the Alq3 had a higher glass transition temperature as measured by differential scanning calorimetry, while the 2,5-bis(6'-(2',2"-bipyridyl))-1,1-dimethyl-3,4-diphenylsilole had a higher electron mobility in actual electric field intensity as measured by TOF (Time of Flight) method. In the TOF method, electron mobility is determined by irradiating the surface of a test sample with pulsed light and measuring a transient current representing the movement of carriers, generated by the pulsed light, through the test sample. Further, comparison of an organic EL device comprising an electron transport layer 6 formed only from Alq3 with an organic EL device comprising an electron transport layer 6 formed only from 2,5-bis(6'-(2',2"-bipyridyl))-1,1-dimethyl-3,4-diphenylsilole showed that the organic EL device comprising an electron transport layer 6 formed only from Alq3 had a longer initial luminance half-life.

After formation of the electron transport layer 6, a 0.5 mm thick cathode interface layer consisting of lithium fluoride was then deposited by vacuum vapor deposition onto the electron transport layer 6. The lithium fluoride deposition was carried out using a carbon crucible under a vacuum of approximately 5.0 × 10⁻⁵ Pa and at a deposition rate of 0.03 nm/s.

Next, a 100 nm thick cathode 7 consisting of aluminum was deposited by vacuum vapor deposition onto the cathode interface layer. The aluminum deposition was carried out using a tungsten boat under a vacuum of approximately 5.0 × 10⁻⁵ Pa and at a deposition rate of 1.0 nm/s.

Table 1 shows the results of measurement into the initial luminance half-life, and power efficiency and current efficiency at a luminance of 1000 cd/m² of the organic EL device prepared in the manner described above. Luminance was measured using a luminance measuring device (manufactured by Topcon Co., product name BM7). Initial luminance half-life was measured as the duration required for the luminance of the organic EL device to drop to 1200 cd/m² under the condition that the current necessary to emit luminance at 2400 cd/m² in the initial state was continuously supplied to the organic EL device.

### Examples 2 to 6

In Examples 2 to 6, organic EL devices were prepared under the same conditions as those in Example 1, except for the weight percentage of the 2,5-bis(6'-(2',2"-bipyridyl))-1,1-dimethyl-3,4-diphenylsilole with respect to the electron transport layer 6 being respectively 10%, 20%, 30%, 40% and 50%. The results of measurement into the initial luminance half-life, and power efficiency and current efficiency at a luminance of 1000 cd/m² of the prepared organic EL devices are shown in Table 1.

### Comparative Example 1

In Comparative Example 1, an organic EL device was prepared in the same manner as in Example 1, except that the electron transport layer 6 was formed of only Alq3 rather than being formed of two materials. The Alq3 deposition was carried out under vacuum of approximately 5.0 × 10⁻⁵ Pa and at a deposition rate of 0.1 nm/s. The thickness of the electron transport layer 6 was 20 nm. The results of measurement into the initial luminance half-life, and power efficiency and current efficiency at a luminance of 1000 cd/m², of the prepared organic EL device are shown in Tables 1 and 3.

### Comparative Example 2

In Comparative Example 2, an organic EL device was prepared under the same conditions as those in Example 1, except for the weight percentage of the 2,5-bis(6'-(2',2"-bipyridyl))-1,1-dimethyl-3,4-diphenylsilole with respect to the electron transport layer 6 being 60%. The results of measurement into the initial luminance half-life, and power efficiency and current efficiency at a luminance of 1000 cd/m², of the prepared organic EL device are shown in Table 1.

**Table 1**

| | 2,5-bis(6'-(2',2"-bipyridyl))-1,1-dimethyl-3,4-diphenylsilole weight percentage (%) | Power efficiency (lm/W) | Current efficiency (cd/A) | Initial luminance half-life (hr) |
|---|---|---|---|---|
| Ex.1 | 1 | 2.9 | 4.4 | 170 |
| Ex.2 | 10 | 3.1 | 4.6 | 167 |
| Ex.3 | 20 | 3.3 | 4.8 | 167 |
| Ex.4 | 30 | 3.5 | 5.0 | 163 |
| Ex.5 | 40 | 3.7 | 5.2 | 163 |
| Ex.6 | 50 | 3.7 | 5.2 | 162 |
| Com. Ex.1 | 0 | 2.0 | 3.6 | 173 |
| Com. Ex.2 | 60 | 3.8 | 5.3 | 117 |

### Evaluation

Table 1 shows that the organic EL devices of Examples 1 to 6 and Comparative Example 2, in which the electron transport layer 6 was formed by co-deposition of Alq3 and 2,5-bis(6'-(2',2"-bipyridyl))-1,1-dimethyl-3,4-diphenylsilole, had excellent power efficiency and current efficiency as compared with the organic EL device of Comparative Example 1, in which the electron transport layer 6 was formed of only Alq3. In addition, the organic EL devices of Examples 1 to 6 and Comparative Example 1 had a longer initial luminance half-life than the organic EL device of Comparative Example 2. This therefore suggests that a long initial luminance half-life can be combined with high luminous efficiency when the weight percentage of 2,5-bis(6'-(2',2"-bipyridyl))-1,1-dimethyl-3,4-diphenylsilole as a share of the electron transport layer 6 is 1% or more and 50% or less.

### Example 7

In Example 7, an organic EL device was prepared under the same conditions as those in Example 1, except that BAlq was used in place of Alq3 as a second organic compound. The results of measurement into the initial luminance half-life, and power efficiency and current efficiency at a luminance of 1000 cd/m², of the prepared organic EL device are shown in Table 2. The BAlq is a type of quinolinolate metal complex which possesses the structure as shown in the below Formula 6.

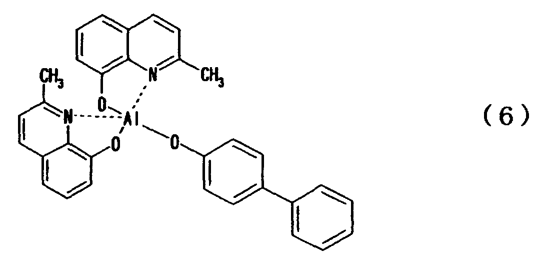

Comparison of the BAlq and 2,5-bis(6'-(2',2"-bipyridyl))-1,1-dimethyl-3,4-diphenylsilole showed that the BAlq had a higher glass transition temperature and that the 2,5-bis(6'-(2',2"-bipyridyl))-1,1-dimethyl-3,4-diphenylsilole had a higher electron mobility in actual electric field intensity. Further, comparison of an organic EL device comprising an electron transport layer 6 formed only from BAlq with an organic EL device comprising an electron transport layer 6 formed only from 2,5-bis(6'-(2',2"-bipyridyl))-1,1-dimethyl-3,4-diphenylsilole showed that the organic EL device comprising an electron transport layer 6 formed only from BAlq had a longer initial luminance half-life.

### Examples 8 to 12

In Examples 8 to 12, organic EL devices were prepared under the same conditions as those in Example 7, except for the weight percentage of the 2,5-bis(6'-(2',2"-bipyridyl))-1,1-dimethyl-3,4-diphenylsilole with respect to the electron transport layer 6 being respectively 10%, 20%, 30%, 40% and 50%. The results of measurement into the initial luminance half-life, and power efficiency and current efficiency at a luminance of 1000 cd/m², of the prepared organic EL devices are shown in Table 2.

### Comparative Example 3

In Comparative Example 3, an organic EL device was prepared in the same manner as in Example 1, except that the electron transport layer 6 was formed of only BAlq rather than being formed of two materials. The BAlq deposition was carried out at a deposition rate of 0.1 nm/s, and the thickness of the electron transport layer 6 was 20 nm. The results of measurement into the initial luminance half-life, and power efficiency and current efficiency at a luminance of 1000 cd/m², of the prepared organic EL device are shown in Tables 2 and 4.

### Comparative Example 4

In Comparative Example 4, an organic EL device was prepared under the same conditions as those in Example 7, except for the weight percentage of the 2,5-bis(6'-(2',2"-bipyridyl))-1,1-dimethyl-3,4-diphenylsilole with respect to the electron transport layer 6 being 60%. The results of measurement into the initial luminance half-life, and power efficiency and current efficiency at a luminance of 1000 cd/m², of the prepared organic EL device are shown in Table 2.

**Table 2**

| | 2,5-bis(6'-(2',2"-bipyridyl))-1,1-dimethyl-3,4-diphenylsilole weight percentage (%) | power efficiency (lm/W) | Current efficiency (cd/A) | Initial luminance half-life (hr) |
|---|---|---|---|---|
| Ex.7 | 1 | 2.5 | 4.3 | 159 |
| Ex.8 | 10 | 2.9 | 4.4 | 158 |
| Ex.9 | 20 | 3.1 | 4.6 | 158 |
| Ex.10 | 30 | 3.3 | 4.9 | 157 |
| Ex.11 | 40 | 3.6 | 5.2 | 155 |
| Ex.12 | 50 | 3.7 | 5.5 | 155 |
| Com. Ex.3 | 0 | 1.5 | 3.5 | 160 |
| Com. Ex.4 | 60 | 3.8 | 5.6 | 114 |

### Evaluation

Table 2 shows that the organic EL devices of Examples 7 to 12 and Comparative Example 4, in which the electron transport layer 6 was formed by co-deposition of BAlq and 2,5-bis(6'-(2',2"-bipyridyl))-1,1-dimethyl-3,4-diphenylsilole, had excellent power efficiency and current efficiency as compared with the organic EL device of Comparative Example 3, in which the electron transport layer 6 was formed of only BAlq. In addition, the organic EL devices of Examples 7 to 12 and Comparative Example 3 had a longer initial luminance half-life than the organic EL device of Comparative Example 4. This therefore suggests that a long initial luminance half-life can be combined with high luminous efficiency when the weight percentage of 2,5-bis(6'-(2',2"-bipyridyl))-1,1-dimethyl-3,4-diphenylsilole as a share of the electron transport layer 6 is 1% or more and 50% or less.

### Example 13

In Example 13, an organic EL device was prepared under the same conditions as those in Example 1, except for the 2,5-bis(6'-(2',2"-bipyridyl))-1,1-dimethyl-3,4-diphenylsilole being replaced with 2,5-bis(6'-(2',2"-bipyridyl))-1,1-dimethyl-3,4-bis(2-methylphenyl)silole as the first organic compound. The results of measurement into the initial luminance half-life, and power efficiency and current efficiency at a luminance of 1000 cd/m², of the prepared organic EL devices are shown in Table 3. The 2,5-bis(6'-(2',2"-bipyridyl))-1,1-dimethyl-3,4-bis(2-methylphenyl) silole is one type of silole derivative and has a structure as represented by the below formula 7, and a molecular weight of 598.8.

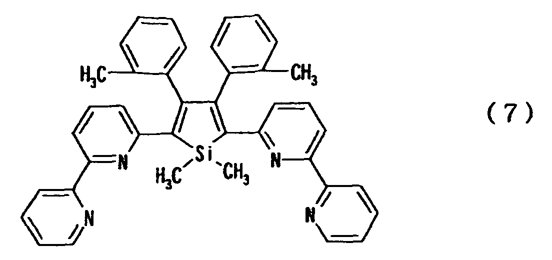

Comparison of the Alq3 and 2,5-bis(6'-(2',2"-bipyridyl))-1,1-dimethyl-3,4-bis(2-methylphenyl) silole showed that the Alq3 had a higher glass transition temperature and that the 2,5-bis(6'-(2',2"-bipyridyl))-1,1-dimethyl-3,4-bis(2-methylphenyl) silole had a higher electron mobility in actual electric field intensity. Further, comparison of an organic EL device comprising an electron transport layer 6 formed only from Alq3 with an organic EL device comprising an electron transport layer 6 formed only from 2,5-bis(6'-(2',2"-bipyridyl))-1,1-dimethyl-3,4-bis(2-methylphenyl) silole showed that the organic EL device comprising an electron transport layer 6 formed only from Alq3 had a longer initial luminance half-life.

### Examples 14 to 18

In Examples 14 to 18, organic EL devices were prepared under the same conditions as those in Example 13, except for the weight percentage of the 2,5-bis(6'-(2',2"-bipyridyl))-1,1-dimethyl-3,4-bis(2-methylphenyl) silole with respect to the electron transport layer 6 being respectively 10%, 20%, 30%, 40% and 50%. The results of measurement into the initial luminance half-life, and power efficiency and current efficiency at a luminance of 1000 cd/m², of the prepared organic EL devices are shown in Table 3.

### Comparative Example 5

In Comparative Example 5, an organic EL device was prepared under the same conditions as those in Example 13, except for the weight percentage of the 2,5-bis(6'-(2',2"-bipyridyl))-1,1-dimethyl-3,4-bis(2-methylphenyl) silole with respect to the electron transport layer 6 being 60%. The results of measurement into the initial luminance half-life, and power efficiency and current efficiency at a luminance of 1000 cd/m², of the prepared organic EL device are shown in Table 3.

**Table 3**

| | 2,5-bis(6'-(2',2"-bipyridyl))-1,1-dimethyl-3,4-bis(2-methylphenyl)sil ole weight percentage (%) | Power efficiency (lm/W) | Current efficiency (cd/A) | Initial luminance half-life (hr) |
|---|---|---|---|---|
| Ex.13 | 1 | 3.1 | 4.6 | 171 |
| Ex.14 | 10 | 3.3 | 4.9 | 170 |
| Ex.15 | 20 | 3.8 | 5.2 | 169 |
| Ex.16 | 30 | 4.3 | 5.5 | 166 |
| Ex.17 | 40 | 4.5 | 5.7 | 165 |
| Ex.18 | 50 | 4.5 | 5.8 | 165 |
| Com. Ex.1 | 0 | 2 | 3.6 | 172 |
| Com. Ex.5 | 60 | 4.5 | 5.9 | 119 |

### Evaluation

Table 3 shows that the organic EL devices of Examples 13 to 18 and Comparative Example 5, in which the electron transport layer was formed by co-deposition of Alq3 and 2,5-bis(6'-(2',2"-bipyridyl))-1,1-dimethyl-3,4-bis(2-methylphenyl) silole, had excellent power efficiency and current efficiency as compared with the organic EL device of Comparative Example 1, in which the electron transport layer 6 was formed of only Alq3. In addition, the organic EL devices of Examples 13 to 18 and Comparative Example 1 had a longer initial luminance half-life than the organic EL device of Comparative Example 5. This therefore suggests that a long initial luminance half-life can be combined with high luminous efficiency when the weight percentage of 2,5-bis(6'-(2',2"-bipyridyl))-1,1-dimethyl-3,4-bis(2-methylphenyl) silole as a share of the electron transport layer 6 is 1% or more and 50% or less.

### Example 19

In Example 19, an organic EL device was prepared under the same conditions as those in Example 13, except for the Alq3 being replaced with BAlq as the second organic compound. The results of measurement into the initial luminance half-life, and power efficiency and current efficiency at a luminance of 1000 cd/m², of the prepared organic EL devices are shown in Table 4.

Comparison of the BAlq and 2,5-bis(6'-(2',2"-bipyridyl))-1,1-dimethyl-3,4-bis(2-methylphenyl) silole showed that the BAlq had a higher glass transition temperature and that the 2,5-bis(6'-(2',2"-bipyridyl))-1,1-dimethyl-3,4-bis(2-methylphenyl) silole had a higher electron mobility in actual electric field intensity. Further, comparison of an organic EL device comprising an electron transport layer 6 formed only from BAlq with an organic EL device comprising an electron transport layer 6 formed only from 2,5-bis(6'-(2',2"-bipyridyl))-1,1-dimethyl-3,4-bis(2-methylphenyl) silole showed that the organic EL device comprising an electron transport layer 6 formed only from BAlq had a longer initial luminance half-life.

### Examples 20 to 24

In Examples 20 to 24, organic EL devices were prepared under the same conditions as those in Example 19, except for the weight percentage of the 2,5-bis(6'-(2',2"-bipyridyl))-1,1-dimethyl-3,4-bis(2-methylphenyl) silole with respect to the electron transport layer 6 being respectively 10%, 20%, 30%, 40% and 50%. The results of measurement into the initial luminance half-life, and power efficiency and current efficiency at a luminance of 1000 cd/m², of the prepared organic EL devices are shown in Table 4.

### Comparative Example 6

In Comparative Example 6, an organic EL device was prepared under the same conditions as those in Example 19, except for the weight percentage of the 2,5-bis(6'-(2',2"-bipyridyl))-1,1-dimethyl-3,4-bis(2-methylphenyl) silole with respect to the electron transport layer 6 being 60%. The results of measurement into the initial luminance half-life, and power efficiency and current efficiency at a luminance of 1000 cd/m², of the prepared organic EL device are shown in Table 4.

**Table 4**

| | 2,5-bis(6'-(2',2"-bipyridyl))-1,1-dimethyl-3,4-bis(2-methylphenyl)sil ole weight percentage (%) | Power efficiency (lm/W) | Current efficiency (cd/A) | Initial luminance half-life (hr) |
|---|---|---|---|---|
| Ex.19 | 1 | 2.8 | 4.6 | 160 |
| Ex.20 | 10 | 2.9 | 4.6 | 158 |
| Ex.21 | 20 | 3.3 | 4.8 | 158 |
| Ex.22 | 30 | 3.9 | 5.2 | 155 |
| Ex.23 | 40 | 3.9 | 5.5 | 153 |
| Ex.24 | 50 | 4.2 | 5.7 | 153 |
| Com. Ex.3 | 0 | 1.5 | 3.5 | 160 |
| Com. Ex.6 | 60 | 4.2 | 5.9 | 123 |

### Evaluation

Table 4 shows that the organic EL devices of Examples 19 to 24 and Comparative Example 6, in which the electron transport layer 6 was formed by co-deposition of BAlq and 2,5-bis(6'-(2',2"-bipyridyl))-1,1-dimethyl-3,4-bis(2-methylphenyl) silole, had excellent power efficiency and current efficiency as compared with the organic EL device of Comparative Example 3, in which the electron transport layer 6 was formed of only BAlq. In addition, the organic EL devices of Examples 19 to 24 and Comparative Example 3 had a longer initial luminance half-life than the organic EL device of Comparative Example 6. This therefore suggests that a long initial luminance half-life can be combined with high luminous efficiency when the weight percentage of 2,5-bis(6'-(2',2"-bipyridyl))-1,1-dimethyl-3,4-bis(2-methylphenyl) silole as a share of the electron transport layer 6 is 1% or more and 50% or less.

## Claims

1. An organic electroluminescent device comprising a pair of electrodes and a plurality of organic compound layers, which include an electron transport layer, provided between the pair of electrodes, the organic electroluminescent device **characterized in that**
the electron transport layer including at least a first organic compound and a second organic compound, wherein
the first organic compound possesses a higher electron mobility than the second organic compound; and
the second organic compound possesses a higher glass transition temperature than the first organic compound.

2. An organic electroluminescent device comprising a pair of electrodes and a plurality of organic compound layers, which include an electron transport layer, provided between the pair of electrodes, the organic electroluminescent device **characterized in that**
the electron transport layer including at least a first organic compound and a second organic compound, wherein
the first organic compound possesses a higher electron mobility than the second organic compound; and wherein
the first and second organic compounds are selected so that a second organic electroluminescent device has a longer initial luminance half-life than a first organic electroluminescent device, provided that the first organic electroluminescent device has an electron transport layer formed only of the first organic compound, and the second organic electroluminescent device has an electron transport layer formed only of the second organic compound.

3. The organic electroluminescent device according to claim 1 or 2, **characterized in that** the first organic compound is a silole derivative.

4. The organic electroluminescent device according to any one of claims 1 to 3, **characterized in that** the first organic compound has a molecular weight of 400 or more.

5. The organic electroluminescent device according to any one of claims 1 to 4, **characterized in that** the second organic compound is a metal complex.

6. The organic electroluminescent device according to claim 5, **characterized in that** the metal complex is a quinolinolate metal complex.

7. The organic electroluminescent device according to any one of claims 1 to 6, **characterized in that** the first organic compound is from 1% or more to 50% or less by weight of the total weight of the electron transport layer.

8. The organic electroluminescent device according to any one of claims 1 to 7, **characterized in that** the first and second organic compounds are mixed in the electron transport layer.

9. The organic electroluminescent device according to claim 8, **characterized in that** the electron transport layer is formed by co-deposition of the first and second organic compounds.

10. The organic electroluminescent device according to any one of claims 1 to 7, **characterized in that** the electron transport layer has a first layer of the first organic compound and a second layer of the second organic compound.

11. The organic electroluminescent device according to any one of claims 1 to 10, **characterized in that** the electron transport layer has a thickness of from 5 to 100 nm.

12. The organic electroluminescent device according to any one of claims 1 to 11, **characterized in that** a hole injection layer, a hole transport layer and a light-emitting layer are further provided between the pair of electrodes as the organic compound layer.
